# FASCICULE DE BREVET EUROPEEN

(11) **EP 2 939 276 B1**
(45) Date de publication et mention de la délivrance du brevet: **12.06.2019**
(21) Numéro de dépôt: 13821896.1
(22) Date de dépôt: 27.12.2013
(51) Int. Cl.: H01L 33/08, B82Y 20/00, H01L 33/18, H01L 33/24, H01L 31/0352, H01L 31/0304, H01L 31/109, H01L 31/0735, H01L 33/00, H01L 33/32, H01L 33/06, H01L 31/18

(54) **DISPOSITIF OPTO-ÉLECTRONIQUE À MICROFILS OU NANOFILS**
OPTOELEKTRONISCHES BAUTEIL MIT MIKROSTÄBEN ODER NANOSTÄBEN
OPTOELECTRONIC DEVICE HAVING MICROWIRES OR NANOWIRES

(30) Priorité: 28.12.2012 FR 1262927; 28.12.2012 FR 1262929
(43) Date de publication de la demande: 04.11.2015
(73) Titulaire: Aledia, 38040 Grenoble Cedex (FR)
(72) Inventeur: AMSTATT, Benoît, F-38000 Grenoble (FR)
(74) Mandataire: Cabinet Beaumont
(86) Numéro de dépôt international: PCT/FR2013/053272
(87) Numéro de publication internationale: WO 2014/102512

(56) Documents cités:
- EP-A1- 2 333 847
- WO-A1-2010/005381
- WO-A2-2012/054477
- WO-A2-2012/156620
- DE-A1-102010 012 711
- US-A1- 2008 149 944
- US-A1- 2011 309 382
- US-A1- 2012 068 153
- US-A1- 2012 217 474
- US-B2- 7 829 443
- ANJIA GU ET AL: "Design and growth of IIIâ V nanowire solar cell arrays on low cost substrates", 35TH IEEE PHOTOVOLTAIC SPECIALISTS CONFERENCE (PVSC), 20-25 JUNE 2010, HONOLULU, HI, USA, IEEE, PISCATAWAY, NJ, USA, 20 juin 2010 (2010-06-20), pages 2034-2037, XP031784502, ISBN: 978-1-4244-5890-5

## Description

La présente demande de brevet revendique la priorité des demandes de brevet français FR12/62927 et FR12/62929.

### Domaine

La présente description concerne de façon générale les dispositifs optoélectroniques comprenant des microfils ou nanofils semiconducteurs et leurs procédés de fabrication.

Par dispositifs optoélectroniques, on entend des dispositifs adaptés à effectuer la conversion d'un signal électrique en un rayonnement électromagnétique ou inversement, et notamment des dispositifs dédiés à la détection, la mesure ou l'émission d'un rayonnement électromagnétique ou des dispositifs dédiés à des applications photovoltaïques.

### Exposé de l'art antérieur

On s'intéresse plus particulièrement ici à l'amélioration des dispositifs optoélectroniques à microfils ou nanofils de types radiaux comprenant une zone active formée à la périphérie d'un microfil ou nanofil.

Les microfils ou les nanofils considérés ici comprennent un matériau semiconducteur comportant majoritairement un élément du groupe III et un élément du groupe V (par exemple du nitrure de gallium GaN), appelé par la suite composé III-V.

De tels dispositifs sont par exemple décrits dans la demande de brevet français non publiée N° 12/58729 déposée le 18 septembre 2012.

Les documents DE102010012711-A1, WO2012/054477-A2, EP 2333847-A1, US2008/157057-A1 et KR10-2010-0082215 décrivent des dispositifs de l'art antérieur.

### Résumé

Ainsi, on prévoit ici un dispositif optoélectronique comprenant des microfils ou nanofils dont chacun comprend au moins une portion active entre deux portions isolées, la portion active étant entourée d'une couche active, la portion active étant à flancs inclinés ou comprenant au moins une partie ayant un diamètre différent du diamètre d'au moins l'une des deux portions isolées.

Selon un mode de réalisation, la portion active comprend au moins une première portion se prolongeant par une deuxième portion, la première portion étant la plus proche du support des microfils ou nanofils, les première et deuxième portions étant à flancs droits et de diamètres différents, les première et deuxième portions étant à flancs inclinés avec des inclinaisons différentes, la première portion étant à flancs inclinés et la deuxième portion étant à flancs droits ou la première portion étant à flancs droits et la deuxième portion étant à flancs inclinés.

Selon un mode de réalisation, la partie de la couche active entourant la première portion active et la partie de la couche active entourant la deuxième portion active sont adaptées à émettre ou capter de la lumière à des longueurs d'onde différentes.

Selon un mode de réalisation, la première ou la deuxième portion est à flancs inclinés et a une section droite qui diminue en s'éloignant du support des microfils ou nanofils.

Selon un mode de réalisation, la première ou la deuxième portion est à flancs inclinés et a une section droite qui augmente en s'éloignant du support des microfils ou nanofils.

Selon un mode de réalisation, chaque microfil ou nanofil comprend une troisième portion prolongeant la deuxième portion, la troisième portion étant à flancs droits ou à flancs inclinés.

Selon un mode de réalisation, le dispositif comprend une alternance de portions isolées et de portions actives, chaque portion active étant à flancs inclinés ou comprenant au moins une partie ayant un diamètre différent du diamètre d'au moins l'une des deux portions isolées.

Selon un mode de réalisation, le dispositif comprend une alternance de portions isolées et de portions actives, les différentes portions actives ayant des diamètres différents.

Selon un mode de réalisation, chaque couche active est entourée d'une couche d'électrode.

Selon un mode de réalisation, au moins deux portions actives ont des flancs orientés selon des plans cristallins différents.

Selon un mode de réalisation, les couches actives entourant au moins deux portions actives sont adaptées à émettre ou capter de la lumière à des longueurs d'onde différentes.

Selon un mode de réalisation, chaque couche active comprend une structure à puits quantiques multiples.

Selon un mode de réalisation, les portions isolées et les portions actives comprennent majoritairement un composé III-V.

Selon un mode de réalisation, le composé III-V est un composé III-N, notamment choisi parmi le groupe comprenant le nitrure de gallium, le nitrure d'aluminium, le nitrure d'indium, le nitrure de gallium et d'indium, le nitrure de gallium et d'aluminium et le nitrure de gallium, d'aluminium et d'indium.

Selon un mode de réalisation, chaque portion isolée est entourée d'une couche de matériau diélectrique ayant une épaisseur comprise entre une monocouche atomique et 10 nm.

Selon un mode de réalisation, la hauteur totale de chaque portion de chaque microfil ou nanofil est supérieure ou égale à 500 nm.

Selon un mode de réalisation, la portion la plus éloignée du support est une portion isolée.

Il est également prévu un procédé de fabrication d'un dispositif optoélectronique tel que défini précédemment dans lequel les portions isolées sont réalisées dans un réacteur avec des premières proportions de précurseurs de composés III-V et un dopant tel que le silicium, et dans lequel la portion active est réalisée dans le même réacteur dans des conditions différentes de fonctionnement et avec un taux de dopant plus faible que celui des portions isolées ou nul.

Selon un mode de réalisation, la portion active est réalisée avec des pressions de fonctionnement plus faibles que les portions isolées.

Selon un mode de réalisation, la portion active est réalisée avec des proportions de précurseurs des composés III-V distinctes de celles des portions isolées.

Selon un mode de réalisation, la première portion est réalisée dans un réacteur avec des premières conditions de fonctionnement du réacteur, et la deuxième portion est réalisée dans le même réacteur avec des deuxièmes conditions de fonctionnement différentes des premières conditions de fonctionnement.

Selon un mode de réalisation, les première et deuxième portions comprennent majoritairement un composé III-V et la première ou la deuxième portion est réalisée en faisant augmenter ou diminuer le rapport de proportions de précurseurs des composés III-V avec un taux de variation constant à 10 % près.

Selon un mode de réalisation, les première et deuxième portions comprennent majoritairement un composé III-V et la première portion est réalisée avec un premier rapport de proportions de précurseurs des composés III-V à une première valeur constante à 10 % près et la deuxième portion est réalisée avec un deuxième rapport de proportions de précurseurs des composés III-V constant à 10 % près et différent du premier rapport.

Selon un mode de réalisation, la première ou la deuxième portion est réalisée en faisant augmenter ou diminuer la pression dans le réacteur avec un taux de variation constant à 10 % près.

Selon un mode de réalisation, la première portion est réalisée avec une première pression dans le réacteur constante à 10 % près et la deuxième portion est réalisée avec une deuxième pression dans le réacteur constante à 10 % près et différente de la première pression.

### Brève description des dessins

Ces objets, caractéristiques et avantages, ainsi que d'autres seront exposés en détail dans la description suivante de modes de réalisation particuliers faite à titre non limitatif en relation avec les figures jointes parmi lesquelles :
la figure 1 est une coupe, partielle et schématique, d'un dispositif optoélectronique à microfils ou nanofils ;
la figure 2 est une coupe, partielle et schématique, d'un mode de réalisation d'un dispositif optoélectronique à microfils ou nanofils ;
la figure 3 est une coupe, partielle et schématique, d'une variante de réalisation d'un dispositif optoélectronique à microfils ou nanofils ;
la figure 4 est une coupe, partielle et schématique, d'un autre mode de réalisation d'un dispositif optoélectronique à microfils ou nanofils ; et
la figure 5 est une vue agrandie d'une partie de la figure 4.

### Description détaillée

Par souci de clarté, de mêmes éléments ont été désignés par de mêmes références aux différentes figures et, de plus, comme cela est habituel dans la représentation des circuits électroniques, les diverses figures ne sont pas tracées à l'échelle. En outre, seuls les éléments utiles à la compréhension de la présente description ont été représentés et seront décrits. En particulier, les moyens de commande des dispositifs optoélectroniques décrits ci-après sont à la portée de l'homme de l'art et ne sont pas décrits.

Dans la suite de la description, sauf indication contraire, les termes "sensiblement", "environ" et "de l'ordre de" signifient "à 10 % près". En outre, on entend par "composé principalement constitué d'un matériau" ou "composé à base d'un matériau" qu'un composé comporte une proportion supérieure ou égale à 95 % dudit matériau, cette proportion étant préférentiellement supérieure à 99 %.

Le terme "microfil" ou "nanofil" désigne une structure tridimensionnelle de forme allongée dont au moins deux dimensions, appelées dimensions mineures, sont comprises entre 5 nm et 2,5 µm, de préférence entre 50 nm et 2,5 µm, la troisième dimension, appelée dimension majeure, étant au moins égale à 1 fois la plus grande des dimensions mineures, de préférence au moins 5 fois et encore plus préférentiellement au moins 10 fois. Dans certains modes de réalisation, les dimensions mineures peuvent être inférieures ou égales à environ 1000 nm, de préférence comprises entre 100 nm et 300 nm. Dans certains modes de réalisation, la hauteur de chaque microfil ou nanofil peut être supérieure ou égale à 500 nm, de préférence comprise entre 1 µm et 50 µm.

La section droite des microfils ou nanofils peut avoir différentes formes, telles que, par exemple, une forme ovale, circulaire ou polygonale, notamment triangulaire, rectangulaire, carrée ou hexagonale. Ainsi, on comprendra que, quand on mentionne ici le "diamètre" d'un microfil ou nanofil ou d'une couche déposée sur ce microfil ou nanofil, il s'agit d'une grandeur associée au périmètre de la structure visée, correspondant, par exemple, au diamètre du disque ayant la même surface que la section droite du fil.

Les microfils ou nanofils peuvent être, au moins en partie, formés à partir de matériaux semiconducteurs comportant majoritairement un composé III-V, par exemple des composés III-N. Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également être utilisés, par exemple, le phosphore ou l'arsenic. De façon générale, les éléments dans le composé III-V peuvent être combinés avec différentes fractions molaires.

Dans certains modes de réalisation, les microfils ou nanofils peuvent comprendre un dopant parmi le groupe comprenant un dopant de type P du groupe II, par exemple, du magnésium (Mg), du zinc (Zn), du cadmium (Cd) ou du mercure (Hg), un dopant du type P du groupe IV, par exemple du carbone (C) ou un dopant de type N du groupe IV comprenant, par exemple, le silicium (Si), le germanium (Ge), le sélénium (Se), le souffre (S), le terbium (Tb) et l'étain (Sn).

Les microfils ou nanofils sont formés sur une face d'un substrat. Le substrat peut correspondre à une structure monobloc ou correspondre à une couche recouvrant un support constitué d'un autre matériau. Le substrat est, par exemple, un substrat semiconducteur, tel qu'un substrat en silicium, en germanium, en carbure de silicium, en un composé III-V, tel que du GaN ou du GaAs, ou un substrat en ZnO. Le substrat peut être en un matériau conducteur, par exemple en métal, ou en un matériau isolant, par exemple en saphir, en verre ou en céramique.

Un traitement peut être appliqué au substrat pour favoriser la croissance des microfils ou nanofils à des emplacements déterminés. Un exemple de traitement consiste à recouvrir le substrat d'une couche, appelée couche de nucléation, d'un matériau favorisant la croissance des microfils ou nanofils. Un autre exemple de traitement comprend le dépôt sur le substrat ou sur la couche de nucléation d'une couche d'un matériau diélectrique, la formation d'ouvertures dans la couche du matériau diélectrique pour exposer des parties du substrat ou de la couche de nucléation et la croissance des microfils ou nanofils sur les parties du substrat ou de la couche de nucléation exposées, comme cela est décrit dans le document US 7 829 443. Un autre exemple de traitement comprend le dépôt sur le substrat d'une couche comprenant des portions d'un matériau favorisant chacune la croissance d'un microfil ou nanofil d'un composé III-V selon la polarité de l'élément du groupe V séparées par une région d'un matériau favorisant la croissance du composé III-V selon la polarité de l'élément du groupe III, comme cela est décrit dans la demande de brevet non publiée N°12/58729. Un autre exemple de traitement comprend la formation, sur le substrat, de plots d'un matériau favorisant la croissance des microfils ou nanofils et la réalisation d'un traitement de protection des parties de la surface du substrat non recouvertes par les plots pour y empêcher la croissance de microfils ou nanofils, comme cela est décrit dans la demande de brevet non publiée N°12/60232.

Le procédé de croissance des microfils ou nanofils peut être un procédé du type dépôt chimique en phase vapeur organométallique (MOCVD, acronyme anglais pour Metal-Organic Chemical Vapor Déposition), également connu sous le nom d'épitaxie organométallique en phase vapeur (ou OMVPE, acronyme anglais pour Organo-Metallic Vapor Phase Epitaxy) . Toutefois, des procédés tels que l'épitaxie par jet moléculaire (MBE, acronyme anglais pour Molecular-Beam Epitaxy), la MBE à source de gaz (GSMBE), MBE organométallique (MOMBE), l'épitaxie par couche atomique (ALE, acronyme anglais pour Atomic Layer Epitaxy) ou l'épitaxie hybride en phase vapeur (HVPE, acronyme anglais pour Hybrid Vapor Phase Epitaxy) peuvent être utilisés.

A titre d'exemple, le procédé peut comprendre l'injection dans un réacteur d'un précurseur d'un élément du groupe III et d'un précurseur d'un élément du groupe V. Des exemples de précurseurs d'éléments du groupe III sont le triméthylgallium (TMGa), le triéthylgallium (TEGa), le triméthylindium (TMIn) ou le triméthylaluminium (TMAl). Des exemples de précurseurs d'éléments du groupe V sont l'ammoniac (NH₃), le tertiarybutyl-phosphine (TBP) ou l'arsine (AsH₃).

Un précurseur d'un élément supplémentaire peut être ajouté aux précurseurs du composé III-V. L'élément supplémentaire peut être le silicium (Si). Un exemple de précurseur du silicium est le silane (SiH₄). La présence du précurseur de l'élément supplémentaire conduit à l'incorporation de l'élément supplémentaire dans le composé III-V pour doper ce composé III-V mais également à la formation d'une couche d'un matériau diélectrique principalement constitué de l'élément supplémentaire et de l'élément du groupe V sur les flancs latéraux des cristaux en croissance du composé III-V. La concentration de l'élément supplémentaire dans le composé III-V est comprise entre 10¹⁸ et 10²¹ atomes/cm³. La couche du matériau diélectrique a une épaisseur comprise entre une monocouche atomique et 10 nm. Dans le cas où le composé III-V est du GaN et l'élément supplémentaire est du silicium, le GaN est dopé de type N et sera appelé ici n⁺GaN et la couche de matériau diélectrique est du nitrure de silicium SiN, éventuellement sous forme stoechiométrique, Si₃N₄.

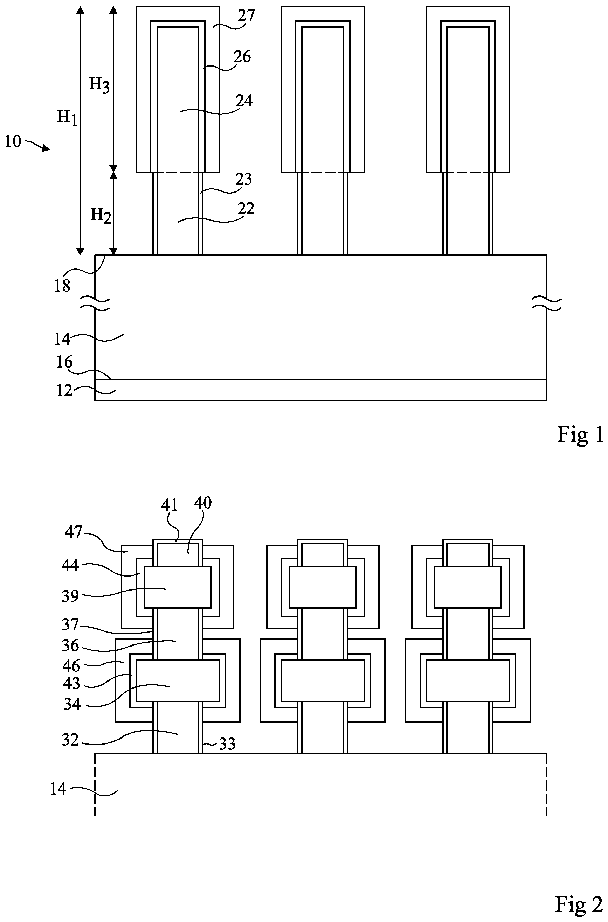

La figure 1 est une coupe, partielle et schématique, d'un dispositif optoélectronique 10 réalisé à partir de nanofils ou de microfils tels que décrits précédemment et adapté à émettre un rayonnement électromagnétique.

Le dispositif 10 comprend, du bas vers le haut en figure 1 :
une première électrode de polarisation 12 ;
un substrat 14, par exemple semiconducteur, comprenant des faces parallèles 16 et 18, la face 16 étant au contact de l'électrode 12 ; la face 18 est éventuellement traitée de façon à favoriser la croissance de microfils ou de nanofils de l'une des nombreuses façons connues dans la technique ;
des microfils ou nanofils (trois microfils ou nanofils étant représentés) de hauteur H₁, chaque microfil ou nanofil comprenant une portion inférieure 22 de hauteur H₂, en contact avec le substrat, et une portion supérieure 24 de hauteur H₃ ;
une couche isolante 23 recouvrant la périphérie de chaque portion inférieure 22 ; et
une couche active 26 recouvrant chaque portion supérieure 24 et une couche de seconde électrode 27 recouvrant chaque couche active 26.

Le substrat 14 est, par exemple, un substrat semiconducteur, tel qu'un substrat en silicium. Le substrat 14 peut être dopé d'un premier type de conductivité, par exemple de type N.

L'électrode 12 peut correspondre à une couche conductrice qui s'étend sur la face 16 du substrat 14. Le matériau formant l'électrode 12 peut être, par exemple, du siliciure de nickel (NiSi), de l'aluminium (Al) ou du titane (Ti).

Chaque microfil ou nanofil 22-24 est une structure semiconductrice allongée dans la direction sensiblement perpendiculaire à la face 18. Chaque microfil ou nanofil 22-24 peut avoir une forme générale cylindrique allongée à base hexagonale. Le diamètre moyen de chaque microfil ou nanofil 22-24 peut être compris entre 50 nm et 2,5 µm et la hauteur H₁ de chaque microfil ou nanofil 22-24 peut être comprise entre 1 µm et 50 µm.

La portion inférieure 22 de chaque nanofil ou microfil est principalement constituée d'un composé III-N, par exemple du nitrure de gallium, dopé par exemple au silicium. Le pourtour de la portion inférieure 22 est recouvert par la couche de diélectrique 23, par exemple du SiN, sur une hauteur H₂. La hauteur H₂ peut être comprise entre 500 nm et 25 µm. La couche de matériau diélectrique 23 a une épaisseur comprise entre une monocouche atomique et 10 nm.

La portion supérieure 24 de chaque microfil ou nanofil, est par exemple au moins partiellement réalisée dans un composé III-N, par exemple du nitrure de gallium. La portion supérieure 24 peut être dopée du premier type de conductivité, par exemple de type N ou ne pas être dopée.

Dans le cas d'un microfil ou nanofil composé principalement de GaN, la structure cristalline du microfil ou nanofil peut être du type wurtzite, le microfil ou nanofil s'étendant selon l'axe C.

La couche active 26 est la couche depuis laquelle est émise la majorité du rayonnement fourni par le dispositif 10 ou dans laquelle est capturée la majorité du rayonnement capturé par le dispositif. La couche active 26 peut comporter des moyens de confinement, tels que des puits quantiques multiples. Elle est, par exemple, constituée d'une alternance de couches de GaN et de InGaN ayant des épaisseurs respectives de 5 à 20 nm (par exemple 8 nm) et de 1 à 10 nm (par exemple 2,5 nm).

Entre la couche active 26 et la couche d'électrode 27, on peut prévoir des couches d'interface non représentées, à savoir une couche de blocage d'électrons en nitrure de gallium et d'aluminium (AlGaN) de type de conductivité opposé à celui du GaN de la couche active, et une couche supplémentaire d'amélioration du contact électrique, par exemple en nitrure de gallium (GaN) fortement dopée, par exemple de type P et qui est appelée p++GaN.

La deuxième électrode 27 est adaptée à assurer la polarisation électrique de chaque portion et à laisser passer le rayonnement électromagnétique émis ou reçu par le dispositif. Le matériau formant l'électrode 27 peut être un matériau semi-transparent tel que de l'oxyde d'indium-étain (ou ITO, acronyme anglais pour Indium Tin Oxide) ou de l'oxyde de zinc dopé à l'aluminium.

A titre d'exemple de formation de la portion inférieure 22 des microfils ou nanofils, dans le cas où cette portion inférieure est en GaN dopé au silicium, un procédé du type MOCVD peut être mis en oeuvre par injection dans un réacteur MOCVD, de type douchette, d'un gaz précurseur du gallium, par exemple le triméthylgallium (TMGa) et d'un gaz précurseur de l'azote, par exemple l'ammoniac (NH₃). A titre d'exemple, on peut utiliser un réacteur MOCVD 3x2", de type douchette, commercialisé par la société AIXTRON. Un rapport de flux moléculaires entre le triméthylgallium et l'ammoniac dans la gamme 5-200, de préférence dans la gamme 10-100, permet de favoriser la croissance de microfils et nanofils. A titre d'exemple, un gaz porteur qui assure la diffusion des organométalliques jusque dans le réacteur vient se charger en organométalliques dans un bulleur de TMGa. Celui-ci est réglé selon les conditions standard de fonctionnement. Un flux de 60 sccm (centimètres cubes standard par minute) est, par exemple choisi pour le TMGa, tandis qu'un flux de 300 sccm est utilisé pour le NH₃ (bouteille standard de NH₃). On utilise une pression d'environ 800 mbar (800 hPa). En outre, du silane est injecté dans le réacteur MOCVD, matériau précurseur du silicium. Le silane peut être dilué dans de l'hydrogène à 1000 ppm et l'on apporte un flux de 20 sccm. La température dans le réacteur est, par exemple, comprise entre 950°C et 1100°C, de préférence entre 990°C et 1060°C. Pour transporter les espèces de la sortie des bulleurs aux deux plénums du réacteur, on utilise un flux de gaz porteur, par exemple du N₂, de 2000 sccm réparti dans les deux plénums. Pour la croissance de la portion supérieure 24 de chaque microfil ou nanofil sur la hauteur H₃, à titre d'exemple, les conditions de fonctionnement du réacteur MOCVD décrites précédemment sont maintenues à l'exception du fait que le flux de silane dans le réacteur est réduit, par exemple d'un facteur supérieur ou égal à 10, ou arrêté.

Le dépôt de la couche active 26 est réalisé de telle sorte qu'il ne se produit que sur la portion supérieure 24 du nanofil et pas sur la portion inférieure 22 recouverte de la couche de diélectrique 23. De même, la couche ou l'ensemble de couches de l'électrode 27 ne se dépose que sur la couche active 26 et pas sur le diélectrique 23.

Le dispositif décrit en figure 1 fonctionne convenablement mais présente divers inconvénients, notamment du fait que l'émission ou la réception associée aux portions de couches actives radiales est partiellement écrantée par la présence des microfils ou nanofils voisins.

De plus, on souhaite parfois réaliser des dispositifs ayant un large spectre de longueurs d'onde d'émission ou de réception.

La figure 2 représente un mode de réalisation d'un dispositif optoélectronique palliant les inconvénients susmentionnés, et notamment pouvant avoir un large spectre d'émission ou de réception, et ayant une plus forte qualité d'émission ou de réception vers le haut. Ce dispositif est élaboré à partir d'un microfil ou nanofil comportant une alternance de portions isolées et de portions actives, les diverses portions actives ayant des diamètres différents.

Le dispositif de la figure 2 comprend un microfil ou nanofil constitué de portions successives :
une portion inférieure 32 isolée, recouverte d'une couche isolante 33, similaire à la portion inférieure 22, 23 décrite précédemment, par exemple en n⁺GaN ;
une portion 34, dite "portion active" ayant un diamètre supérieur à celui de la portion isolée inférieure 32 ;
une deuxième portion isolée 36, revêtue d'une couche isolante 37, similaire à la portion inférieure 32 ;
une nouvelle portion active 39 de diamètre supérieur à celui de la deuxième portion isolée 36, et de préférence inférieur à celui de la portion active 34 ; et
à nouveau une portion isolée 40, revêtue d'une couche diélectrique 41, similaire à la portion inférieure 32, 33.

Les portions actives 34, 39 sont revêtues de couches actives, respectivement 43, 44, elles-mêmes revêtues d'une structure d'électrode 46, 47.

En raison des diamètres différents des portions actives 34, 39, les dépôts de couches actives se font selon des épaisseurs et/ou des proportions de matériaux différentes. Notamment, dans le cas où les couches actives comprennent une structure à puits quantiques comprenant une alternance de couches de GaN et de InGaN, la proportion d'indium est modifiée quand le dépôt s'effectue sur des structures de diamètres différents.

Il en résulte que les longueurs d'onde d'émission liées aux couches actives 43 formées sur la portion active 34 seront différentes de celles des couches actives 44 formées sur la portion active 39. Par exemple, dans le cas de couches actives à base de puits quantiques multiples comprenant une alternance de couches de InGaN et de couches de GaN, la couche active formée sur la portion 34, d'un diamètre d'environ 2,5 µm, émet à une longueur d'onde de 440 nm (dans le bleu) tandis que la couche active formée sur la portion 39, de diamètre 1,5 µm, émet à une longueur d'onde plus élevée, par exemple 520 nm. On peut ainsi obtenir un dispositif ayant des propriétés d'émission ou de réception large bande. En particulier, le spectre d'émission ou de réception obtenu peut être caractéristique d'une lumière blanche. Par rapport à un dispositif optoélectronique comprenant des microfils ou nanofils émettant de la lumière bleue et une couche à base de phosphore absorbant une partie de la lumière bleue et émettant de la lumière jaune, de sorte que le spectre global d'émission du dispositif optoélectronique soit proche de celui de la lumière blanche, le dispositif optoélectronique selon le présent mode de réalisation ne nécessite pas de couche de phosphore pour fournir de la lumière blanche.

En outre, si le diamètre de la portion active inférieure 34 est supérieur au diamètre de la portion active supérieure 39, on comprendra que l'émission vers le haut ou la réception de la lumière provenant du haut sera améliorée par rapport au cas de la structure de la figure 1.

Divers procédés peuvent être utilisés pour former des portions actives 34, 39 de nanofils ou microfils de GaN ayant des diamètres différents de celui des portions isolées 32, 36 de n⁺GaN sur lesquelles elles sont formées. Pour cela, si on forme les portions isolées 32, 36 par le procédé décrit précédemment, on modifie des paramètres de fonctionnement du réacteur pour la formation des portions actives de microfils ou nanofils 34, 39. Selon un mode de réalisation, la pression est modifiée et/ou la composition relative des précurseurs d'éléments du groupe III et des précurseurs d'éléments du groupe V est modifiée. Plus précisément, une diminution de la pression dans le réacteur lors de la formation d'une portion active par rapport à la pression utilisée pour la formation de la portion isolée sous-jacente entraîne une augmentation du diamètre de la portion active par rapport à la portion isolée sous-jacente. En outre, une augmentation du ratio entre le flux de gaz du précurseur de l'élément du groupe V et le flux de gaz du précurseur de l'élément du groupe III par rapport au ratio utilisé pour la formation de la portion isolée sous-jacente entraîne une augmentation du diamètre de la portion active par rapport à la portion isolée sous-jacente.

On note que, si la variation des paramètres est brutale, il se présente un palier de diamètre brutal. Par contre, si cette variation de paramètre est progressive, il peut exister une zone intermédiaire conique entre les portions de microfils ou de nanofils de diamètre distincts. Cette zone intermédiaire conique est constituée de plans semi-polaires. Selon un mode de réalisation, chaque nanofil ou microfil peut comprendre une portion active entre deux portions isolées correspondant à une portion conique à flancs inclinés.

A titre d'exemple, la hauteur de chacune des portions 32, 34, 36, 39 et 40 est de l'ordre de 2 à 6 µm et le diamètre de chacune des portions est :
pour les portions isolées 32, 36 et 40 : diamètre de 100 nm à 2,5 µm, par exemple 1 µm. Ces portions sont réalisées avec une pression dans le réacteur relativement élevée, par exemple 800 mbar (0,08 MPa) ;
pour la portion active 34 : diamètre de 150 nm à 4 µm, par exemple 2,5 µm. Cette portion peut être réalisée en diminuant la pression à une valeur inférieure à 800 mbar, par exemple 200 mbar (0,02 MPa) ;
pour la portion active 39 : diamètre inférieur (ou éventuellement égal) à celui de la portion 34, donc compris entre 150 nm et 4 µm, par exemple 1,75 µm. Dans ce cas, la pression dans le réacteur doit être comprise entre celles utilisées pour la portion 34 et les portions 32, 36, 40, par exemple une valeur de 400 mbars.

On note que, dans le mode de réalisation de la figure 2, les épaisseurs de l'ensemble de la couche active et de la couche d'électrode et les distances entre les portions de micro ou nanofils 34, 39 sont telles que les couches d'électrode 46 et 47 ne se rejoignent pas de sorte que l'on peut polariser différemment les couches actives correspondantes. Ceci ne correspond qu'à un mode de réalisation du dispositif décrit.

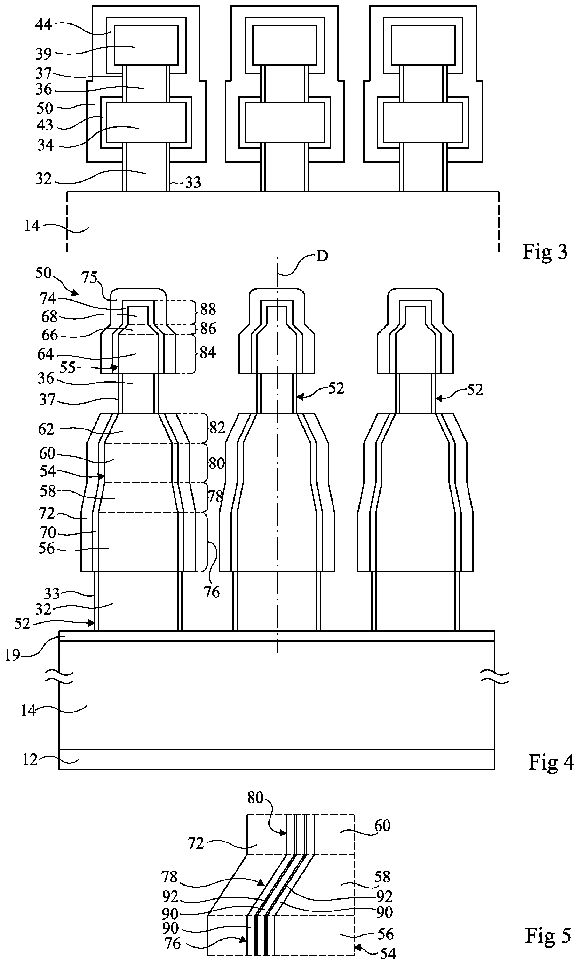

La figure 3 représente une variante dans laquelle les diverses dimensions sont choisies de sorte que les couches d'électrodes 46 et 47 constituent une électrode unique 50 de sorte que l'on peut appliquer une même polarisation à l'ensemble des couches actives du dispositif. De plus, dans le mode de réalisation de la figure 3, on n'a pas représenté de portion isolée supérieure correspondant à la portion isolée 40 de la figure 2. Il en résulte une émission favorisée vers le haut. Il est connu que les couches actives déposées horizontalement sur les microfils ou nanofils ont une longueur d'onde d'émission/réception distincte de celle des couches actives radiales. Ceci peut contribuer, si on le souhaite, à l'augmentation du spectre de longueur d'onde de fonctionnement du dispositif. En outre, lorsque les microfils ou nanofils sont suffisamment proches les uns des autres, les électrodes 50 peuvent être au moins en partie jointives au niveau des portions actives les plus proches du support.

De plus, on a représenté en figures 2 et 3 deux portions actives susceptibles d'être revêtues de couches actives et de couches d'électrode. Ce nombre de régions peut être multiplié.

La figure 5 représente un autre mode de réalisation d'un dispositif optoélectronique 50. Ce dispositif 50 est élaboré à partir de fils 52 d'axe D comportant chacun une alternance de portions isolées et de portions actives, les portions actives étant recouvertes de la couche active, au moins l'une des portions actives comprenant au moins deux portions de section constante et de diamètres différents et/ou au moins une portion de section constante et une portion à flancs inclinés.

A titre d'exemple, le dispositif 50 comprend l'ensemble des éléments du dispositif représenté en figure 2 à la différence que la portion active 34 est remplacée par une portion active 54 et que la portion active 39 est remplacée par une portion active 55.

La portion active 54 comprend successivement une portion 56 à section droite constante, une portion 58 à flancs inclinés par rapport à l'axe D et dont la section droite diminue du bas vers le haut, une portion 60 à section droite constante ayant un diamètre strictement inférieur au diamètre de la portion 56 et une portion 62 à flancs plus inclinés que la portion 58 et dont la section droite diminue du bas vers le haut.

La portion active 55 comprend successivement une portion 64 à section droite constante ayant un diamètre strictement inférieur au diamètre de la portion 60, une portion 66 à flancs plus inclinés que la portion 62 et dont la section droite diminue du bas vers le haut et une portion 68 à section droite constante ayant un diamètre strictement inférieur au diamètre de la portion 64.

Dans le cas où les portions 54, 55 sont constituées principalement de GaN de polarité N, la croissance du fil est réalisée selon l'axe -c. A titre d'exemple, les flancs latéraux des portions 56, 60, 64 et 68 correspondent à des plans cristallins (1-100), dits non-polaires, parallèles à l'axe D. Les flancs inclinés des portions 58, 62, 66 correspondent à des plans cristallins semi-polaires dont les angles d'inclinaison par rapport à l'axe D du fil 52 dépendent des conditions de croissance du fil. A titre d'exemple, les flancs inclinés de la portion 58 correspondent à des plans cristallins (30-3-1) inclinés d'environ 10° par rapport à l'axe D. Les flancs inclinés de la portion 62 correspondent à des plans cristallins (20-2-1) inclinés d'environ 15° par rapport à l'axe D. Les flancs inclinés de la portion 66 correspondent à des plans cristallins (11-2-2) inclinés d'environ 32° par rapport à l'axe D. Bien entendu, les flancs inclinés peuvent correspondre à d'autres plans cristallographiques, par exemple les plans cristallographiques (1-10-1) ou (1-101). En outre, la portion 68 comprend au sommet du fil une face perpendiculaire à l'axe du fil qui correspond à un plan polaire - c.

A titre d'exemple, les dimensions de chacune des portions 56, 58, 60, 62, 64, 66, 68 sont :
pour la portion 56, diamètre : 2 µm - hauteur : 1 µm ;
pour la portion 58, hauteur : 1 µm ;
pour la portion 60, diamètre : 1,6 µm - hauteur : 1 µm ;
pour la portion 62, hauteur : 1 µm ;
pour la portion 64, diamètre : 1,14 µm - hauteur : 1 µm ;
pour la portion 66, hauteur : 500 nm ;
pour la portion 68, diamètre : 500 nm - hauteur : 500 nm.

Les portions 56, 58, 60, 62 sont revêtues d'une couche active 70, elle-même revêtue d'une structure d'électrode 72. Les portions 64, 66, 68 sont revêtues d'une couche active 74, elle-même revêtue d'une structure d'électrode 75. La portion isolée 36 n'est pas recouverte d'une couche active.

Comme cela a été décrit précédemment pour les couches actives 43, 44, les couches actives 70, 74 peuvent comporter des moyens de confinement, tels que des puits quantiques multiples. Les couches d'électrode 72, 75 peuvent avoir la même composition que les couches d'électrode 46, 47 décrites précédemment.

La couche active 70 comprend successivement, du bas vers le haut, des régions 76, 78, 80, 82 qui épousent respectivement les formes des portions 56, 58, 60, 62 qu'elles recouvrent et la couche active 74 comprend successivement, du bas vers le haut, des régions 84, 86, 88 qui épousent respectivement les formes des portions 64, 66, 68.

En particulier, les régions 76, 80, 84 et 88 sont des régions à flancs droits et les régions 78, 82 et 86 sont des régions à flancs inclinés correspondant à des plans cristallins dont les inclinaisons sont sensiblement identiques aux inclinaisons des portions 58, 62 et 66 recouvertes respectivement par ces régions 78, 82 et 86.

La figure 5 représente une vue agrandie d'une partie du dispositif optoélectronique 50 selon un mode de réalisation selon lequel la couche active 70 comprend une structure à puits quantiques comprenant une alternance de couches de GaN 90 et de couches de InGaN 92, deux couches de InGaN 92 et trois couches de GaN 90 étant représentées en figure 5.

En raison de l'alternance de régions à flancs inclinés et de régions à section droite constante, chaque couche active 70, 74 comprend une succession de régions ayant des épaisseurs ou des proportions de matériaux différentes. Notamment, dans le cas où chaque couche active 70, 74 comprend au moins une couche de InGaN, la proportion d'indium est modifiée quand le dépôt s'effectue sur des structures à flancs droits ou sur des structures à flancs plus ou moins inclinés. En outre, les épaisseurs des couches de InGaN et de GaN sont différentes quand ces couches sont formées sur des structures à flancs droits ou sur des structures à flancs plus ou moins inclinés. En effet, la vitesse de croissance, sur des structures à flancs plus ou moins inclinés, des couches formant les puits quantiques ainsi que l'incorporation d'indium dans ces mêmes puits est différente selon les différents diamètres des régions à section droite constante et les différentes inclinaisons des régions à flancs inclinés.

Il en résulte que les longueurs d'onde d'émission liées à chaque région à flancs droits ou à flancs inclinés de la couche active 50 sont différentes. En outre, on peut également modifier les différentes proportions hauteur/diamètre des régions de chaque couche active en fonction des longueurs d'onde visées et des longueurs d'onde que l'on veut combiner. On peut ainsi obtenir un dispositif ayant des propriétés d'émission ou de réception large bande. En particulier, le spectre d'émission ou de réception obtenu peut être caractéristique d'une lumière blanche. Par rapport à un dispositif optoélectronique comprenant des fils émettant de la lumière bleue et une couche à base de phosphore absorbant une partie de la lumière bleue et émettant de la lumière jaune, de sorte que le spectre global d'émission du dispositif optoélectronique soit proche de celui de la lumière blanche, le dispositif optoélectronique selon le présent mode de réalisation ne nécessite pas de couche de phosphore pour fournir de la lumière blanche.

A titre d'exemple, dans le cas où chaque couche active 70, 74 comprend des puits quantiques multiples et est constituée d'une alternance de couches de GaN ayant une épaisseur variant autour de 8 nm et de couches de InGaN ayant une épaisseur variant autour de 2,5 nm, les longueurs d'onde d'émission des régions des couches actives 70, 74 sont les suivantes :
région 76 : 440 nm ;
région 78 : 480 nm ;
région 80 : 520 nm ;
région 82 : 510 nm ;
région 84 : 540 nm ;
région 86 : 490 nm ; et
région 88 : 560 nm.

En outre, si le diamètre de la portion active 56 est supérieur au diamètre de la portion active 60, lui-même supérieur au diamètre de la portion active 64, lui-même supérieur au diamètre de la portion active 68, on comprend que l'émission vers le haut ou la réception de la lumière provenant du haut sera améliorée par rapport au cas du dispositif optoélectronique 10 de la figure 1.

Le procédé de fabrication du dispositif comprend la croissance de la portion 54 en formant successivement les portions 56, 58, 60, 62 et la croissance de la portion 55 en formant successivement les portions 64, 66, 68. Le rapport entre le flux moléculaire du précurseur de l'élément du groupe V et le flux moléculaire du précurseur de l'élément du groupe III est appelé rapport V/III dans la suite de la description. A titre d'exemple, chaque portion à flancs droits est obtenue en maintenant le rapport V/III à une valeur donnée dans une plage de rapports V/III parmi plusieurs plages distinctes de rapports V/III. En outre, chaque portion à flancs inclinés est obtenue en appliquant un taux de variation, ou gradient, au rapport V/III à une valeur donnée dans une plage de taux de variation parmi plusieurs plages distinctes de taux de variation. A titre d'exemple, pour des portions à flancs inclinés dont la section diminue du bas vers le haut, l'obtention des flancs inclinés est obtenue par un taux de variation négatif du rapport V/III, réalisé par exemple par une augmentation du flux moléculaire du précurseur de l'élément du groupe III. Pour chaque plage de taux de variation du rapport V/III, une inclinaison différente des flancs inclinés est obtenue.

Selon un autre exemple, chaque portion à flancs droits est obtenue en maintenant une pression constante dans le réacteur dans une plage de pression parmi plusieurs plages distinctes de pression. En outre, chaque portion à flancs inclinés est obtenue en appliquant un taux de variation, ou gradient, à la pression dans le réacteur à une valeur donnée dans une plage de taux de variation parmi plusieurs plages distinctes de taux de variation. Pour chaque plage de taux de variation de la pression, une inclinaison différente des flancs inclinés est obtenue.

Selon un autre exemple, chaque portion à flancs droits est obtenue en maintenant à la fois le rapport V/III constant et la pression constante dans le réacteur. En outre, chaque portion à flancs inclinés est obtenue en appliquant un gradient au rapport V/III et un gradient à la pression dans le réacteur.

A titre d'exemple, pour former la portion 56, les conditions de fonctionnement du réacteur MOCVD décrites précédemment sont maintenues à l'exception du fait que le flux de silane dans le réacteur est réduit, par exemple d'un facteur 10, ou arrêté. Le rapport V/III est alors sensiblement constant à une première valeur. Pour former la portion à flancs inclinés suivante 58, un premier gradient négatif est appliqué au rapport V/III de la première valeur de rapport V/III jusqu'à une deuxième valeur de rapport V/III. Pour former la portion à flancs droits suivante 60, le rapport V/III est maintenu à la deuxième valeur. Pour former la portion à flancs inclinés suivante 62, un deuxième gradient négatif est appliqué au rapport V/III de la deuxième valeur de rapport V/III jusqu'à une troisième valeur de rapport V/III.

Selon une variante du dispositif optoélectronique 50, la portion active 54 ou 55 peut comporter des première et deuxième portions de sections sensiblement constantes et de diamètres différents reliées par une marche, c'est-à-dire par une face sensiblement perpendiculaire à l'axe du fil, les première et deuxième portions étant recouvertes de la couche active.

Selon un mode de réalisation, les portions actives sont recouvertes d'une couche de GaN avant la formation de la couche active proprement dite. Cette couche de GaN a une épaisseur supérieure à 10 nm, de préférence supérieure à 20 nm, encore plus préférentiellement supérieure à 40 nm. Cette couche de GaN épouse les flancs latéraux droits du fil mais à chaque passage de marche forme des plans semi-polaires dont l'inclinaison dépend de la largeur de la marche.

Les inventeurs ont mis en évidence que, lors de la formation de la couche active par épitaxie sur chaque portion active, chaque sous-couche de la couche active comprend des régions qui croissent selon des plans non polaires sur au moins une partie des flancs latéraux des portions de section constante et des régions qui croissent selon des plans semi-polaires au niveau de chaque transition entre des portions de section constante adjacentes. L'inclinaison des régions à flancs inclinés dépend notamment de la différence entre les diamètres de deux portions successives de section constante. De préférence, chaque marche a une profondeur inférieure ou égale à 100 nm.

Un mode de réalisation du procédé de fabrication de cette variante correspond au procédé décrit précédemment pour la fabrication du dispositif 50 à la différence que les paramètres de croissance sont changés selon un échelon entre deux portions actives successives de section constante et de diamètres différents. A titre d'exemple, le rapport V/III passe, selon un échelon, d'une valeur constante initiale à une valeur constante finale, entre deux portions actives successives de section constante et de diamètres différents.

Selon une autre variante du dispositif optoélectronique 50, la portion active 54 ou 55 comporte au moins une première portion de section constante se prolongeant par une deuxième portion à flancs inclinés dont la section augmente lorsqu'on s'éloigne du substrat, les première et deuxième portions étant recouvertes par la couche active.

En outre, on a représenté sur les figures des modes de réalisation dans lesquels les microfils ou nanofils, recouverts d'une première électrode, sont formés sur une première face d'un support tandis qu'une deuxième électrode est formée sur une deuxième face du support, opposée à la première face. Toutefois, il est clair que la deuxième électrode peut être prévue du côté de la première face.

De plus, bien que, dans les modes de réalisation décrits précédemment, chaque microfil ou nanofil comprenne une portion passivée 32, à la base du microfil ou nanofil en contact avec la face 18, cette portion passivée 32 peut ne pas être présente.

En outre, bien que les modes de réalisation décrits précédemment concernent des composés III-V, ce qui a été décrit peut également être mis en oeuvre pour la fabrication de composés II-VI (par exemple l'oxyde de zinc ZnO) comprenant un matériau semiconducteur comportant majoritairement un élément du groupe II et un élément du groupe VI.

Bien que l'on ait décrit divers modes de réalisation d'un dispositif optoélectronique large bande, on comprendra que chaque élément de ces divers modes de réalisation peut être combiné de façon différente avec les autres éléments.

## Revendications

1. Dispositif optoélectronique comprenant des microfils ou nanofils dont chacun comprend au moins des première et deuxième portions actives (34, 56 ; 39, 58), la première portion active étant entre deux portions isolées (32, 36, 40), chaque portion active étant entourée d'une couche active (46, 47 ; 70) adaptée à émettre de la lumière, chaque portion active étant à flancs inclinés ou au moins deux portions actives ayant des diamètres différents et ayant chacune un diamètre différent du diamètre d'au moins l'une des deux portions isolées, le dispositif comprenant, en outre, des électrodes (46, 47 ; 50 ; 72, 75), dans lequel la partie de la couche active (70) entourant la première portion active et la partie de la couche active entourant la deuxième portion active sont adaptées à émettre de la lumière à des longueurs d'onde différentes.

2. Dispositif selon la revendication 1, dans lequel la portion active comprend au moins une première portion (56) se prolongeant par une deuxième portion (58, 60), la première portion étant la plus proche du support (14) des microfils ou nanofils, les première et deuxième portions étant à flancs droits et de diamètres différents, les première et deuxième portions étant à flancs inclinés avec des inclinaisons différentes, la première portion étant à flancs inclinés et la deuxième portion étant à flancs droits ou la première portion étant à flancs droits et la deuxième portion étant à flancs inclinés.

3. Dispositif selon la revendication 2, dans lequel la première ou la deuxième portion (58) est à flancs inclinés et a une section droite qui diminue en s'éloignant du support (14) des microfils ou nanofils.

4. Dispositif selon la revendication 2, dans lequel la première ou la deuxième portion est à flancs inclinés et a une section droite qui augmente en s'éloignant du support des microfils ou nanofils.

5. Dispositif selon l'une quelconque des revendications 1 à 4, comprenant une alternance de portions isolées (32, 36, 40) et de portions actives (34, 39), chaque portion active étant à flancs inclinés ou comprenant au moins une partie ayant un diamètre différent du diamètre d'au moins l'une des deux portions isolées.

6. Dispositif selon la revendication 5, comprenant une alternance de portions isolées (32, 36, 40) et de portions actives (34, 39), les portions actives ayant des diamètres différents.

7. Dispositif selon la revendication 5 ou 6, dans lequel au moins deux portions actives (34, 39) ont des flancs orientés selon des plans cristallins différents.

8. Dispositif selon l'une quelconque des revendications 5 à 7, dans lequel les couches actives (43, 44) entourant au moins deux portions actives (34, 39) sont adaptées à émettre ou capter de la lumière à des longueurs d'onde différentes.

9. Dispositif selon l'une quelconque des revendications 5 à 8, dans lequel chaque couche active (43, 44) comprend une structure à puits quantiques multiples.

10. Dispositif selon l'une quelconque des revendications 1 à 9, dans lequel les portions isolées (32, 36, 40) et les portions actives (34, 39) comprennent majoritairement un composé III-V.

11. Dispositif selon l'une quelconque des revendications 1 à 10, dans lequel chaque portion isolée (32, 36, 40) est entourée d'une couche (33, 37) de matériau diélectrique ayant une épaisseur comprise entre une monocouche atomique et 10 nm.

12. Procédé de fabrication d'un dispositif optoélectronique selon l'une quelconque des revendications 1 à 11, dans lequel les portions isolées sont réalisées dans un réacteur avec des premières proportions de précurseurs de composés III-V et un dopant tel que le silicium, et dans lequel la portion active est réalisée dans le même réacteur dans des conditions différentes de fonctionnement et avec un taux de dopant plus faible que celui des portions isolées ou nul.

13. Procédé selon la revendication 12, dans lequel la portion active est réalisée avec des proportions de précurseurs des composés III-V distinctes de celles des portions isolées.

14. Procédé selon la revendication 12 pour la fabrication d'un dispositif optoélectronique selon la revendication 2, dans lequel la première portion (56) est réalisée dans un réacteur avec des premières conditions de fonctionnement du réacteur, et dans lequel la deuxième portion (58, 60) est réalisée dans le même réacteur avec des deuxièmes conditions de fonctionnement différentes des premières conditions de fonctionnement.

## Patentansprüche

1. Optoelektronische Vorrichtung, die Mikrodrähte oder Nanodrähte aufweist, von denen jeder wenigstens erste und zweite aktive Teile (34, 56; 39, 58) aufweist, wobei sich der erste aktive Teil zwischen zwei isolierten Teilen (32, 36, 40) befindet und jeder aktive Teil von einer aktiven Schicht (46, 47; 70) umgeben ist, die geeignet ist, Licht zu emittieren, wobei jeder aktive Teil geneigte Seiten oder wenigstens zwei aktive Teile mit unterschiedlichen Durchmessern aufweist und jeder einen Durchmesser aufweist, der sich vom Durchmesser wenigstens eines der beiden isolierten Teile unterscheidet, wobei die Vorrichtung ferner Elektroden (46, 47; 50; 72, 75) aufweist, wobei der Teil der aktiven Schicht (70), der den ersten aktiven Teil umgibt, und der Teil der aktiven Schicht, der den zweiten aktiven Teil umgibt, geeignet sind, Licht mit unterschiedlichen Wellenlängen zu emittieren.

2. Vorrichtung nach Anspruch 1, wobei der aktive Teil wenigstens einen ersten Teil (56) aufweist, der sich in einem zweiten Teil (58, 60) erstreckt, wobei der erste Teil dem Träger (14) der Mikrodrähte oder Nanodrähte am nächsten ist, wobei die ersten und zweiten Teile gerade Seiten und verschiedene Durchmesser aufweisen, wobei die ersten und zweiten Teile geneigte Seiten mit unterschiedlichen Neigungen aufweisen, wobei der erste Teil geneigte Seiten aufweist und der zweite Teil gerade Seiten aufweist, oder wobei der erste Teil gerade Seiten aufweist und der zweite Teil geneigte Seiten aufweist.

3. Vorrichtung nach Anspruch 2, wobei der erste oder der zweite Teil (58) geneigte Seiten aufweist und einen Querschnitt aufweist, der mit zunehmendem Abstand zum Träger (14) der Mikro- oder Nanodrähte abnimmt.

4. Vorrichtung nach Anspruch 2, wobei der erste oder der zweite Teil geneigte Seiten aufweist und einen Querschnitt aufweist, der mit zunehmendem Abstand zum Träger der Mikrodrähte oder Nanodrähte zunimmt.

5. Vorrichtung nach einem der Ansprüche 1 bis 4, die einen Wechsel von isolierten Teilen (32, 36, 40) und aktiven Teilen (34, 39) aufweist, wobei jeder aktive Teil geneigte Seiten aufweist oder wenigstens einen Teil mit einem Durchmesser aufweist, der sich vom Durchmesser wenigstens eines der beiden isolierten Teile unterscheidet.

6. Vorrichtung nach Anspruch 5, die einen Wechsel von isolierten Teilen (32, 36, 40) und aktiven Teilen (34, 39) aufweist, wobei die aktiven Teile unterschiedliche Durchmesser aufweisen.

7. Vorrichtung nach einem der Ansprüche 5 bis 6, wobei wenigstens zwei aktive Teile (34, 39) Seiten aufweisen, die entlang verschiedener Kristallebenen ausgerichtet sind.

8. Vorrichtung nach einem der Ansprüche 5 bis 7, wobei die aktiven Schichten (43, 44), die wenigstens zwei aktive Teile (34, 39) umgeben, geeignet sind, Licht mit unterschiedlichen Wellenlängen zu emittieren oder einzufangen.

9. Vorrichtung nach einem der Ansprüche 5 bis 8, wobei jede aktive Schicht (43, 44) eine multiple Quantentopfstruktur aufweist.

10. Vorrichtung nach einem der Ansprüche 1 bis 9, wobei die isolierten Teile (32, 36, 40) und die aktiven Teile (34, 39) hauptsächlich eine III-V-Verbindung aufweisen.

11. Vorrichtung nach einem der Ansprüche 1 bis 10, wobei jeder isolierte Teil (32, 36, 40) von einer Schicht (33, 37) aus dielektrischem Material mit einer Dicke im Bereich von einer atomaren Monoschicht bis 10 nm umgeben ist.

12. Verfahren zur Herstellung der optoelektronischen Vorrichtung nach einem der Ansprüche 1 bis 11, wobei die isolierten Teile in einem Reaktor mit ersten Anteilen an Vorläufern von III-V-Verbindungen und einem Dotierstoff wie Silizium ausgebildet werden, und wobei der aktive Teil im gleichen Reaktor unter verschiedenen Betriebsbedingungen und mit einer Dotierstoffrate ausgebildet wird, die kleiner als die der isolierten Teile oder gleich Null ist.

13. Verfahren nach Anspruch 12, wobei der aktive Teil mit Anteilen an Vorläufern der III-V-Verbindungen ausgebildet wird, die sich von denen der isolierten Teile unterscheiden.

14. Verfahren nach Anspruch 12 zur Herstellung der optoelektronischen Vorrichtung nach Anspruch 2, wobei der erste Teil (56) in einem Reaktor mit ersten Betriebsbedingungen des Reaktors ausgebildet ist, und wobei der zweite Teil (58, 60) in demselben Reaktor mit anderen Betriebsbedingungen als den ersten Betriebsbedingungen ausgebildet ist.

## Claims

1. An optoelectronic device comprising microwires or nanowires, each of which comprises at least first and second active portions (34, 56; 39, 58), the first active portion being between two insulated portions (32, 36, 40), each active portion being surrounded with an active layer (46, 47; 70) capable of emitting light, each active portion having inclined sides or at least two active portions having different diameters and each having a diameter different from the diameter of at least one of the two insulated portions, the device further comprising electrodes (46, 47; 50; 72, 75), wherein the portion of the active layer (70) surrounding the first active portion and the portion of the active layer surrounding the second active portion are capable of emitting light at different wavelengths.

2. The device of claim 1, wherein the active portion comprises at least one first portion (56) extending in a second portion (58, 60), the first portion being the closest to the support (14) of the microwires or nanowires, the first and second portions having straight sides and different diameters, the first and second portions having inclined sides with different inclinations, the first portion having inclined sides and the second portion having straight sides, or the first portion having straight sides and the second portion having inclined sides.

3. The device of claim 2, wherein the first or the second portion (58) has inclined sides and has a cross-section which decreases as the distance to the support (14) of the microwires or nanowires increases.

4. The device of claim 2, wherein the first or the second portion has inclined sides and has a cross-section which increases as the distance to the support of the microwires or nanowires increases.

5. The device of any of claims 1 to 4, comprising an alternation of insulated portions (32, 36, 40) and of active portions (34, 39), each active portion having inclined sides or comprising at least a portion having a diameter different from the diameter of at least one of the two insulated portions.

6. The device of claim 5, comprising an alternation of insulated portions (32, 36, 40) and of active portions (34, 39), the active portions having different diameters.

7. The device of any of claims 5 to 6, wherein at least two active portions (34, 39) have sides oriented along different crystal planes.

8. The device of any of claims 5 to 7, wherein the active layers (43, 44) surrounding at least two active portions (34, 39) are capable of emitting or capturing light at different wavelengths.

9. The device of any of claims 5 to 8, wherein each active layer (43, 44) comprises a multiple quantum well structure.

10. The device of any of claims 1 to 9, wherein the insulated portions (32, 36, 40) and the active portions (34, 39) mainly comprise a III-V compound.

11. The device of any of claims 1 to 10, wherein each insulated portion (32, 36, 40) is surrounded with a layer (33, 37) of dielectric material having a thickness in the range from one atomic monolayer to 10 nm.

12. A method of manufacturing the optoelectronic device of any of claims 1 to 11, wherein the insulated portions are formed in a reactor with first proportions of precursors of III-V compounds and a dopant such as silicon, and wherein the active portion is formed in the same reactor in different operating conditions and with a dopant rate smaller than that of the insulated portions or equal to zero.

13. The method of claim 12, wherein the active portion is formed with proportions of precursor of the III-V compounds different from those of the insulated portions.

14. The method of claim 12 of manufacturing the optoelectronic device of claim 2, wherein the first portion (56) is formed in a reactor with first operating conditions of the reactor, and wherein the second portion (58, 60) is formed in the same reactor with operating conditions different from the first operating conditions.
